(19) Europäisches Patentamt
European Patent Office
Office européen des brevets

(11) **EP 3 926 909 B1**

(12) **FASCICULE DE BREVET EUROPEEN**

(45) Date de publication et mention de la délivrance du brevet:
**02.08.2023 Bulletin 2023/31**

(21) Numéro de dépôt: **21179973.9**

(22) Date de dépôt: **17.06.2021**

(51) Classification Internationale des Brevets (IPC):
**H04L 27/26** $^{(2006.01)}$    **H04L 27/36** $^{(2006.01)}$
**H04J 13/00** $^{(2011.01)}$

(52) Classification Coopérative des Brevets (CPC):
**H04L 27/264; H04L 27/26025; H04L 27/2633; H04L 27/368**

(54) **MODULATEUR OFDM POUR ÉMETTEUR OFDM À FILTRAGE PAR BLOCS, ÉMETTEUR OFDM À FILTRAGE PAR BLOCS ET SYSTÈME D'ÉMISSION/RÉCEPTION ASSOCIÉS**

OFDM-MODULATOR FÜR BLOCKGEFILTERTEN OFDM-SENDER, ENTSPRECHENDER BLOCKGEFILTERTER OFDM-SENDER UND ENTSPRECHENDES SENDE/EMPFANGSSYSTEM

OFDM MODULATOR FOR OFDM TRANSMITTER WITH BLOCK FILTERING, ASSOCIATED OFDM TRANSMITTER WITH BLOCK FILTERING AND SYSTEM FOR TRANSMITTING/RECEIVING

(84) Etats contractants désignés:
AL AT BE BG CH CY CZ DE DK EE ES FI FR GB GR HR HU IE IS IT LI LT LU LV MC MK MT NL NO PL PT RO RS SE SI SK SM TR

(30) Priorité: **18.06.2020 FR 2006354**

(43) Date de publication de la demande:
**22.12.2021 Bulletin 2021/51**

(73) Titulaire: **COMMISSARIAT À L'ÉNERGIE ATOMIQUE ET AUX ÉNERGIES ALTERNATIVES**
75015 Paris (FR)

(72) Inventeurs:
• **CASSIAU, Nicolas**
38054 Grenoble Cedex 9 (FR)
• **LAUGEOIS, Marc**
38054 Grenoble Cedex 9 (FR)

(74) Mandataire: **Lavoix**
2, place d'Estienne d'Orves
75441 Paris Cedex 09 (FR)

(56) Documents cités:
**EP-A1- 3 300 325**

• **DEMMER DAVID ET AL: "Block-filtered OFDM: A novel waveform for future wireless technologies", 2017 IEEE INTERNATIONAL CONFERENCE ON COMMUNICATIONS (ICC), IEEE, 21 mai 2017 (2017-05-21), pages 1-6, XP033132888, DOI: 10.1109/ICC.2017.7997061**
• **DEMMER DAVID ET AL: "Filter design for 5G BF-OFDM waveform", 2017 EUROPEAN CONFERENCE ON NETWORKS AND COMMUNICATIONS (EUCNC), IEEE, 12 juin 2017 (2017-06-12), pages 1-5, XP033122252, DOI: 10.1109/EUCNC.2017.7980688**
• **GERZAGUET ROBIN ET AL: "5G Multi-Service Field Trials with BF-OFDM", 2017 IEEE GLOBECOM WORKSHOPS (GC WKSHPS), IEEE, 4 décembre 2017 (2017-12-04), pages 1-5, XP033307264, DOI: 10.1109/GLOCOMW.2017.8269210**
• **GERZAGUET ROBIN ET AL: "Block-filtered OFDM: A new promising waveform for multi-service scenarios", 2017 IEEE INTERNATIONAL CONFERENCE ON COMMUNICATIONS (ICC), IEEE, 21 mai 2017 (2017-05-21), pages 1-6, XP033132253, DOI: 10.1109/ICC.2017.7996399**

**Description**

La présente invention concerne un modulateur OFDM d'un ensemble de $M$ modulateurs OFDM en parallèle d'un émetteur OFDM à filtrage par blocs propre à communiquer en utilisant une bande de transmission et une numérologie variable(s) en temps réel, chaque modulateur OFDM étant associé à un indice $i$ tel que $0 \leq i \leq M - 1$, $M$ étant constant indépendamment de la numérologie et de la bande de transmission dudit émetteur, l'émetteur OFDM à filtrage par blocs comprenant en outre en amont dudit ensemble un module de conversion série-parallèle configuré pour convertir un flux série de données entrantes en $N_{FFT}$ porteuses parallèles de données, le modulateur OFDM étant configuré pour recevoir en entrée un bloc de $N_c$ porteuses de données consécutives desdites $N_{FFT}$ porteuses parallèles de données, le modulateur OFDM comprenant au moins un module de prédistortion configuré pour recevoir lesdites $N_c$ porteuses de données consécutives et configuré pour compenser une distorsion introduite ultérieurement par un banc de filtres polyphasés dudit émetteur OFDM, la sortie dudit modulateur OFDM étant connectable à l'entrée du banc de filtres polyphasés.

La présente invention concerne également un émetteur OFDM à filtrage par blocs et un système d'émission/réception associés.

La présente invention concerne de manière générale le domaine des systèmes de télécommunication OFDM (de l'anglais *Orthogonal Frequency Division Multiplexing*) ainsi que celui des systèmes de télécommunication utilisant une modulation multi-porteuse a banc de filtres, encore dénommés systèmes FBMC (de l'anglais *Filter Bank Multi-Carrier).*

Les systèmes de télécommunication utilisant une modulation multi-porteuse sont bien connus dans l'état de la technique. Le principe d'une telle modulation consiste à diviser la bande de transmission en une pluralité de sous-canaux fréquentiels associés à des porteuses et à moduler chacune de ces porteuses par les données à transmettre.

La modulation multi-porteuse la plus répandue est sans aucun doute la modulation OFDM notamment mise en oeuvre dans les réseaux locaux sans fil WLAN, WiFi, dans l'accès internet sans fil à haut débit (WiMax), les systèmes de radiodiffusion numérique (DVB-T, ISDB-T, DAB), les liaisons numériques asymétriques (xDSL), les réseaux cellulaires (LTE), etc.

Dans un système de transmission OFDM, chaque symbole OFDM est précédé d'un intervalle de garde pouvant être un préfixe cyclique, de longueur supérieure à l'étalement temporel de la réponse impulsionnelle du canal, de manière à éliminer l'interférence intersymbole. L'insertion d'un intervalle de garde ou d'un préfixe cyclique conduit toutefois à une perte d'efficacité spectrale. Enfin, l'occupation spectrale d'un signal OFDM étant sensiblement plus importante que la bande de porteuses qu'il utilise en raison de l'étalement des lobes secondaires, la modulation OFDM n'est pas une solution optimale pour des applications nécessitant de forts taux de réjection hors bande.

Plus récemment, grâce à l'augmentation des capacités de calcul numériques, la modulation multi-porteuse par banc de filtres ou FBMC est davantage mise en oeuvre comme alternative à la modulation OFDM. Le principe de la modulation FBMC est basé sur une synthèse par banc de filtres à l'émission et une analyse par banc de filtres à la réception. Les filtres à l'émission et à la réception sont des versions décalées en fréquence et en temps d'un filtre prototype.

L'invention vise encore plus précisément le domaine des communications numériques et plus précisément la cinquième génération de communications mobiles, 5G, conçue pour répondre aux exigences de 2020 et au-delà.

La 5G ne se contente pas d'être associée à une augmentation conséquente en termes de débit et de capacité de données, mais elle vise également de nouveaux types d'utilisation comme l'Internet des objets ou les communications véhiculaires. La technologie 4G actuellement déployée ne fournit pas suffisamment de capacités réseau, ni une architecture adaptée, pour garantir une telle diversité d'utilisation ce qui a motivé la recherche de solutions alternatives de formes d'ondes.

Dans cette optique, un nouveau schéma de modulation prometteur, l'OFDM filtré en bloc BF-OFDM (de l'anglais *Block-Filtered OFDM*) a été introduit dans l'article de D. Demmer intitulé « Block-Filtered OFDM: a novel waveform for future Wireless » publié dans IEEE ICC 2017 Wireless Communications Symposium technologies, du 21 au 25 Mai 2017. La forme d'onde issue de l'OFDM filtré en bloc est compatible avec le standard de communication 3GPP 5G selon la version 15 et suivantes, et offre en effet une excellente localisation des fréquences tout en étant directement intégrable à partir du savoir-faire relatif à l'OFDM et aux principes associées au standard de communication 3GPP LTE. Les systèmes BF-OFDM sont en outre avantageusement modulables pour contrôler les capacités réseau à la demande.

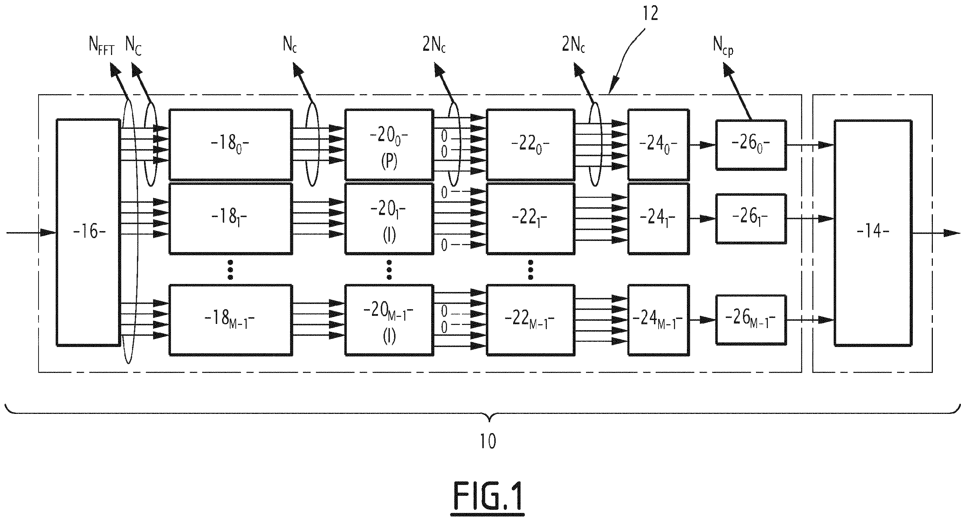

Plus précisément, la figure 1 illustre de manière schématique l'émetteur BF-OFDM 10 divulgué dans l'article précité. Un tel émetteur BF-OFDM 10 comprend deux entités de modulation successives distinctes 12 et 14 correspondant respectivement à une entité 12 de pré-codage OFDM suivie d'un banc 14 de filtres polyphasés. L'entité de pré-codage OFDM 12 comprend une chaîne de six types de modules distincts 16, 18, 20, 22, 24 et 26 successifs.

En particulier, le module 16 est configuré pour convertir un flux série de données en $N_{FFT}$ porteuses parallèles, $N_{FFT}$ étant égal à $M$ fois $N_c$ avec $M$ le nombre de modulateurs OFDM (par la suite appelés indifféremment sous-canaux) modulant $2N_c$ porteuses chacun, chaque modulateur OFDM étant associé à un indice $i$ tel que $0 \leq i \leq M - 1$, dont $N_c$ porteuses nulles. Chaque modulateur OFDM comprenant un suite ordonnée de modules 18, 20, 22, 24 et 26, intégrant notamment une transformée de Fourier inverse discrète IDFT (de l'anglais *Inverse Discrète Fourier Transform*) de taille $2N_c$. La largeur spectrale d'un modulateur OFDM (i.e. sous-canal) étant égale à $N_c\Delta f$, avec $\Delta f$ l'espace entre porteuses.

Les modules 18 sont des modules de type pré-distorsion, chacun configuré pour compenser la distorsion introduite par le banc 14 de filtres polyphasés, et ce pour un bloc de $N_c$ porteuses consécutives distinct d'un module 18 de pré-distorsion à un autre.

Les modules 20 sont des modules de formatage, chacun respectivement connectable aux sorties d'un module 18 de pré-distorsion distinct, et chacun configuré pour répartir les $N_c$ porteuses OFDM reçues sur $2N_c$ porteuses en garantissant le principe d'orthogonalité. Plus précisément, pour les modulateurs OFDM d'indice pair (P), les $N_c$ porteuses de données sont réparties sur les côtés du spectre avec des porteuses nulles au milieu du spectre, les $N_c/2$ premières données du flux entrant dans un des modules 20 de formatage considéré étant placées à la fin du spectre, alors que les $N_c/2$ données suivantes du flux entrant étant placées en début de spectre avec des porteuses nulles au milieu du spectre, ce qui en conséquence introduit des traitements supplémentaires et la complexité matérielle et architecturale associée, de même qu'une interruption du flux des données, ce qui n'est pas souhaitable. Pour les modulateurs OFDM d'indice impair (I) les $N_c$ porteuses de données sont localisées au milieu du spectre avec des porteuses nulles sur les côtés tel qu'illustré par le tableau 1 ci-dessous pour un nombre $N_c$ porteuses de données tel que $N_c = 32$ ou $N_c = 256$.

**[Table 1]**

|  | Nc=32 |  |  |
|---|---|---|---|
| Numéros de porteuses | 0 à 15 | 16 à 47 | 48 à 63 |
| Insertion bord (sous-canal impair) | zéros | données 0 à 31 | Zeros |
| Insertion milieu (sous-canal pair) | données 16 à 31 | zéros | données 0 à 15 |
|  | Nc=256 |  |  |
| Numéros de porteuses | 0 à 127 | 128 à 383 | 384 à 511 |
| Insertion bord (sous-canal impair) | zéros | données 0 à 255 | Zeros |
| Insertion milieu (sous-canal pair) | données 128 à 256 | zéros | données 0 à 127 |

Les modules 22 sont chacun configurés pour appliquer la transformée de Fourier inverse discrète IDFT (de l'anglais *Inverse Discrète Fourier Transform*) de taille $2N_c$ en tant que telle aux $2N_c$ porteuses formatées par le module 20 de formatage qui leur est respectivement associé.

Les modules 24 sont chacun configurés pour convertir les $2N_c$ sorties temporelles parallèles du module 22 qui leur est respectivement associé en un flux série d'échantillons temporels.

Les modules 26 sont ensuite chacun configurés pour insérer un préfixe cyclique dans le flux série du bloc d'échantillons temporels reçu du module 24 qui leur est associé, le préfixe cyclique correspondant à une copie des $N_{cp}$ derniers échantillons temporels du bloc d'échantillons temporels reçu au début de celui-ci.

Les M blocs d'échantillons temporels délivrés par les M modulateurs OFDM sont ensuite filtrés par le banc 14 de filtres polyphases (PPN de l'anglais *PolyPhase Network*).

Toutefois, du fait que le jeu de paramètres de communication associé à la 5G est beaucoup plus important que celui associé à la 4G pour gérer la diversité d'utilisation visée, l'implémentation matérielle d'un tel émetteur BF-OFDM est complexe et gourmande en ressources alors que le matériel associé, notamment sous forme d'un composant logique programmable, tel qu'un FPGA (de l'anglais *Field Programmable Gate Array*) est limité en ressources.

En effet, la 5G se caractérise notamment par une bande de transmission et une numérologie $\mu = \{0,1,2,3\}$ (numéro associé à une valeur prédéterminée de l'espace entre porteuses $\Delta f$) propres toutes deux à varier respectivement et indépendamment en temps réel, tel qu'illustré notamment par le tableau 2 ci-dessous illustrant différents paramétrages de l'émetteur BF-OFDM en considérant un nombre M de modulateurs OFDM (i.e. sous-canaux) constant ; dont la largeur évolue avec la largeur B de bande passante de la bande de transmission :

**[Table 2]**

|  |  | B =50 MHz $N_c\Delta f$ = 3.84 MHz |  |  | B =100 MHz $N_c\Delta f$ = 7.68 MHz |  |  | B =200 MHz $N_c\Delta f$ = 15.36 MHz |  |  |
|---|---|---|---|---|---|---|---|---|---|---|
| $\mu$ | $\Delta f$ (kHz) | $N_c$ | Taille IDFT | $N_{cp}$ | $N_c$ | Taille IDFT | $N_{cp}$ | $N_c$ | Taille IDFT | $N_{cp}$ |
| 0 | 15 | 256 | 512 | 32 | 512 | 1024 | 64 | 1024 | 2048 | 128 |
| 1 | 30 | 128 | 256 | 16 | 256 | 512 | 32 | 512 | 1024 | 64 |

(suite)

| μ | $\Delta f$ (kHz) | B =50 MHz $N_c\Delta f$ = 3.84 MHz | | | B =100 MHz $N_c\Delta f$ = 7.68 MHz | | | B =200 MHz $N_c\Delta f$ = 15.36 MHz | | |
|---|---|---|---|---|---|---|---|---|---|---|
| | | $N_c$ | Taille IDFT | $N_{cp}$ | $N_c$ | Taille IDFT | $N_{cp}$ | $N_c$ | Taille IDFT | $N_{cp}$ |
| 2 | 60 | 64 | 128 | 8 | 128 | 256 | 16 | 256 | 512 | 32 |
| 3 | 120 | 32 | 64 | 4 | 64 | 128 | 8 | 128 | 256 | 16 |

L'architecture d'émetteur divulguée dans l'article précédemment cité illustré par la figure 1 n'est pas adaptée au langage de description du matériel HDL (de l'anglais Hardware Description Language) car selon la numérologie et la bande, susceptibles de changer en temps réel, les paramètres $N_c$, et donc la taille $2N_c$ de l'IDFT et $N_{cp}$ varient impliquant plusieurs problèmes d'implémentation matérielle sur FPGA, à savoir la nécessité d'implémenter plusieurs tailles d'IDFT et de basculer sur l'une ou l'autre implémentation en fonction de la numérologie, d'adapter le code de description du matériel HDL en fonction de la taille du préfixe cyclique, et surtout la complexité de description du module 20 de formatage.

En effet, comme indiqué précédemment, en fonction de la parité d'indice du modulateur (i.e. sous-canal) considéré, les porteuses nulles à insérer sont localisées au milieu du spectre pour les modulateurs OFDM d'indice pair ce qui entraine une interruption du flux de données, ou aux extrémités du spectre pour les modulateurs OFDM d'indice impair. De plus si on considère un ordre d'entrée des données linéaire (i.e. d'indice 0 à $N_c$ - 1), pour les modulateurs OFDM d'indices impairs, cet ordre est conservé, alors que pour les modulateurs d'indices pairs, il convient de sortir d'abord les données d'indice $N_c/2$ à $N_c$ - 1 puis celles de d'indice 0 à $N_2/2$ - 1. En résumé, l'ordre de lecture en sortie du tampon du modulateur diffère selon la parité.

Une telle insertion/inversion d'ordre de données variant en fonction de la parité d'indice du modulateur (i.e. sous-canal) considéré, est difficile à réaliser en langage de description du matériel HDL dans le contexte d'application 5G visé où par ailleurs selon la numérologie et la bande, susceptibles de changer en temps réel, les paramètres $N_c$, et donc la taille $2N_c$ de l'IDFT varient, ou requiert autant de composants logiques programmables, tel qu'un FPGA (de l'anglais *Field Programmable Gate Array*) que de configurations d'émission envisagées ce qui augmenterait drastiquement la charge et le coût d'un tel émetteur.

Le but de la présente invention est par conséquent de proposer une variante d'implémentation d'émetteur BF-OFDM et de système d'émission/réception correspondant qui tienne compte de la complexité d'une implémentation matérielle, à savoir adaptée au langage de description du matériel HDL, permettant notamment une implémentation FPGA.

A cet effet, l'invention porte sur un modulateur OFDM d'un ensemble de M modulateurs OFDM en parallèle d'un émetteur OFDM à filtrage par blocs propre à communiquer en utilisant une bande de transmission et une numérologie, variable(s) en temps réel,

chaque modulateur OFDM étant associé à un indice *i* tel que $0 \leq i \leq M$ - 1, M étant constant indépendamment de la numérologie et de la bande de transmission dudit émetteur,
l'émetteur OFDM à filtrage par blocs comprenant en outre en amont dudit ensemble un module de conversion série-parallèle configuré pour convertir un flux série de données entrantes en $N_{FFT}$ porteuses parallèles de données,
le modulateur OFDM étant configuré pour recevoir en entrée un bloc de $N_c$ porteuses de données consécutives desdites $N_{FFT}$ porteuses parallèles de données,
le modulateur OFDM comprenant au moins un module de prédistortion configuré pour recevoir lesdites $N_c$ porteuses de données consécutives et configuré pour compenser une distorsion introduite ultérieurement par un banc de filtres polyphasés dudit émetteur OFDM, la sortie dudit modulateur OFDM étant connectable à l'entrée du banc de filtres polyphasés, le modulateur OFDM comprenant en outre :

- un module de transformation configuré pour appliquer une transformée de Fourier inverse discrète IDFT de taille constante $N_{IDFT}$ indépendamment de la numérologie et de la bande de transmission dudit émetteur,
- un module de remplissage dont l'entrée est connectée à la sortie du module de prédistortion, et dont la sortie est connecté à l'entrée du module de transformation, le module de remplissage étant configuré pour insérer $(N_{IDFT} - N_c)$ porteuses nulles à la suite des $N_c$ porteuses de données consécutives indépendamment de la parité de l'indice *i* associé audit modulateur OFDM..

Suivant d'autres aspects avantageux de l'invention, le modulateur OFDM comprend une ou plusieurs des caractéristiques suivantes, prises isolément ou suivant toutes les combinaisons techniquement possibles :

- le modulateur OFDM est propre à traiter les données selon leur ordre d'arrivée indépendamment de la valeur de son indice $i$ ;
- le modulateur OFDM comprend en outre :
- un module de conversion parallèle-série configuré pour convertir les $N_{IDFT}$ sorties temporelles parallèles propres à être délivrées par le module de transformation en un flux série d'échantillons temporels, et
- un module d'insertion, dont l'entrée est propre à être connectée à la sortie du module de conversion parallèle-série, le module d'insertion étant configuré pour insérer un temps de garde, correspondant à un nombre $N_{cs}$ prédéterminé d'échantillons temporels additionnels constant indépendamment de la numérologie et de la bande de transmission dudit émetteur ;
- le temps de garde correspond à un préfixe cyclique ;
- le temps de garde correspond à un suffixe cyclique ;
- le modulateur OFDM comprend en outre un module de décimation, localisé en aval dudit module de transformation, le module de décimation étant configuré pour décimer les échantillons temporels obtenus à partir dudit module de transformation d'un facteur égal à $N_{IDFT}/(2N_c)$ ;
- le modulateur OFDM comprend en outre un module de déplacement de spectre configuré pour appliquer aux échantillons, dans leur ordre d'arrivée, une rotation dans le domaine temporel de valeur de $(-1)^{i+1}\pi/2$, avec $i$ l'indice associé audit modulateur OFDM ;

L'invention a également pour objet un émetteur OFDM à filtrage par blocs propre à communiquer en utilisant une bande de transmission et une numérologie variable(s) en temps réel, l'émetteur OFDM comprenant successivement :

- un module de conversion série-parallèle configuré pour convertir un flux série de données entrantes en $N_{FFT}$ porteuses parallèles de données,
- un ensemble de $M$ modulateurs OFDM en parallèle selon l'une quelconque des revendications précédentes, chaque modulateur OFDM étant associé à un indice $i$ tel que $0 \leq i \leq M$ - 1, $M$ étant constant indépendamment de la numérologie et de la bande de transmission dudit émetteur, chaque modulateur OFDM étant configuré pour recevoir en entrée un ensemble de $N_c$ porteuses de données consécutives desdites $N_{FFT}$ porteuses parallèles de données, les ensembles de $N_c$ porteuses consécutives traités par chaque modulateur étant tous disjoints, $N_{FFT}$ étant égal à M fois $N_c$,
- un banc de filtres polyphasés propre à être connecté aux $M$ sorties dudit ensemble de $M$ modulateurs OFDM.

Suivant un autre aspect avantageux de l'émetteur OFDM à filtrage par blocs, le nombre M de modulateurs OFDM est reconfigurable.

L'invention a également pour objet un système d'émission/réception comprenant un émetteur OFDM à filtrage par blocs selon la présente invention.

Ces caractéristiques et avantages de l'invention apparaîtront plus clairement à la lecture de la description qui va suivre, donnée uniquement à titre d'exemple non limitatif, et faite en référence aux dessins annexés, sur lesquels :

- **[Fig 1]** la figure 1 est une représentation schématique d'un émetteur OFDM à filtrage par blocs selon l'état de la technique décrit précédemment;
- **[Fig 2]** la figure 2 est une représentation schématique d'un émetteur OFDM à filtrage par blocs selon la présente invention ;
- **[Fig 3]** la figure 3 est une représentation schématique du traitement mis en oeuvre par un des modulateurs OFDM de l'émetteur OFDM à filtrage par blocs selon la présente invention.

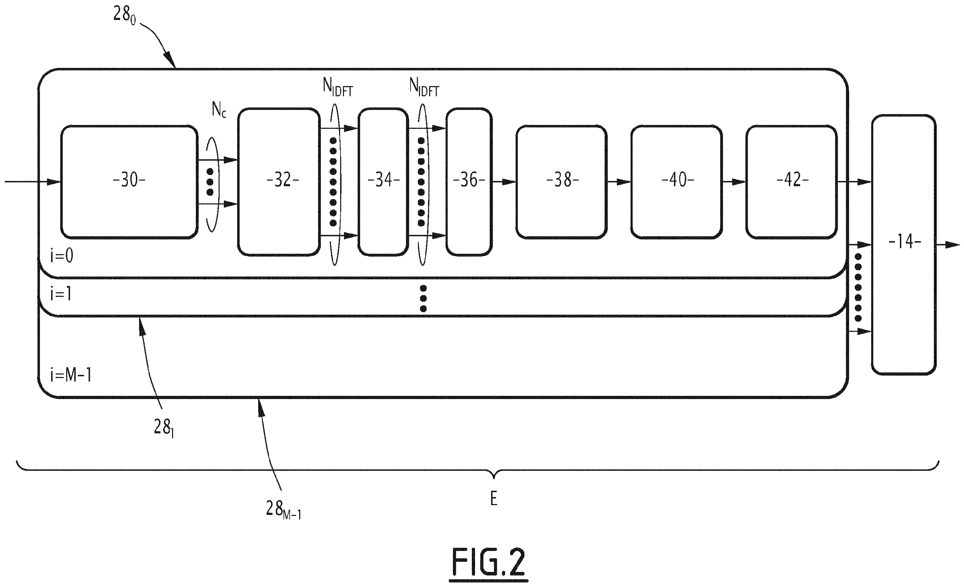

La figure 2 est une représentation schématique d'un émetteur OFDM à filtrage par blocs E selon la présente invention. Plus précisément, l'émetteur E OFDM à filtrage par blocs est propre à communiquer en utilisant une bande de transmission et une numérologie variable(s) en temps réel, l'émetteur E OFDM comprenant successivement, un module de conversion 16 série-parallèle, tel qu'illustré précédemment par la figure 1, configuré pour convertir un flux série de données entrantes en $N_{FFT}$ porteuses parallèles de données, suivi, tel qu'illustré par la figure 2, par un ensemble de $M$ modulateurs OFDM $28_0$, $28_1$, ... , $28_i$, ... , $28_{M-1}$ en parallèle, chaque modulateur OFDM étant associé à un indice $i$ tel que $0 \leq i \leq M$ - 1, $M$ étant constant indépendamment de la numérologie et de la bande de transmission dudit émetteur E, l'ensemble de $M$ modulateurs OFDM $28_0$, $28_1$, ..., $28_i$, ..., $28_{M-1}$ en parallèle étant lui-même suivi par un banc 14 de filtres polyphasés propre à être connecté aux $M$ sorties dudit ensemble de $M$ modulateurs OFDM.

Chaque modulateur OFDM $28_0$, $28_1$, ..., $28_i$, ..., $28_{M-1}$ est configuré pour recevoir en entrée un ensemble de $N_c$ porteuses de données consécutives desdites $N_{FFT}$ porteuses parallèles de données, les ensembles de $N_c$ porteuses consécutives traités par chaque modulateur $28_0$, $28_1$, ..., $28_i$, ..., $28_{M-1}$ étant tous disjoints, $N_{FFT}$ étant égal à M fois $N_c$.

Plus précisément, tel qu'illustré sur la figure 2, chaque modulateur OFDM, notamment le modulateur OFDM $28_0$, comprend un module de prédistortion 30 configuré pour recevoir lesdites $N_c$ porteuses de données consécutives et configuré pour compenser une distorsion introduite ultérieurement par le banc 14 de filtres polyphasés dudit émetteur E OFDM, la sortie dudit modulateur OFDM étant connectable à l'entrée du banc 14 de filtres polyphasés.

Chaque modulateur OFDM, notamment le modulateur OFDM $28_0$, comprend en outre un module de remplissage 32 dont l'entrée est connectée à la sortie du module de prédistortion 30, et dont la sortie est connecté à l'entrée d'un module de transformation 34 configuré pour appliquer une transformée de Fourier inverse discrète IDFT de taille constante $N_{IDFT}$ indépendamment de la numérologie et de la bande de transmission dudit émetteur. Le module de remplissage 32 est configuré pour insérer $(N_{IDFT} - N_c)$ porteuses nulles (dites par la suite zéros portant des données de valeurs nulles) à la suite des $N_c$ porteuses de données consécutives indépendamment de la parité de l'indice i associé audit modulateur OFDM considéré.

Autrement dit, le module de remplissage 32 est dédié à l'insertion de zéros, en utilisant un schéma unique d'insertion de $(N_{IDFT} - N_c)$ zéros, les zéros étant insérés après $N_c$ les données. De plus, les données sont traitées dans leur ordre d'arrivée indépendamment de la parité de l'indice i associé audit modulateur OFDM considéré, (i.e. quel que soit le sous-canal), ce qui résout le problème d'interruption de flux associé à l'architecture d'émetteur précédemment décrite en relation avec la figure 1, puisque chaque modulateur OFDM $28_0$, $28_1$, ..., $28_i$, ..., $28_{M-1}$ est alors propre à traiter les données selon leur ordre d'arrivée indépendamment de la valeur de son indice i.

Ainsi, le module de remplissage 32 joue un double rôle, à savoir d'une part ajouter les $N_c$ porteuses nulles, pour permettre de garantir le principe d'orthogonalité, et d'autre part, remplir de $(N_{IDFT} - 2N_c)$ zéros (i.e. porteuses nulles) supplémentaires l'entrée de la transformée de Fourier inverse discrète IDFT pour n'utiliser qu'une seule taille $N_{IDFT}$ de transformée de Fourier inverse discrète IDFT quelles que soient la numérologie et la bande de transmission.

Un exemple de remplissage de porteuses nulles (i.e. de zéros) est illustré notamment par le tableau 3 ci-dessous pour un nombre $N_c$ porteuses de données tel que $N_c = 32$ et $N_c = 256$ et avec une taille constante $N_{IDFT}$ de transformée de Fourier inverse discrète IDFT telle que : $N_{IDFT} = 512$ quelles que soient la numérologie et la bande de transmission.

**[Table 3]**

| | $N_c = 32$ | |
|---|---|---|
| Numéro de porteuses (indépendamment de la parité de l'indice i associé audit modulateur OFDM (i.e. sous-canal)) | 0 à 31 | 32 à 511 |
| Numéro de donnée | 0 à 31 | Zéros insérés |
| | $N_c = 256$ | |
| Numéro de porteuses (indépendamment de la parité de l'indice i associé audit modulateur OFDM (i.e. sous-canal)) | 0 à 255 | 256 à 511 |
| Numéro de donnée | 0 à 255 | Zéros insérés |

Le module de transformation 34 configuré pour appliquer une transformée de Fourier inverse discrète IDFT est, selon la présente invention, configuré pour réaliser une IDFT de taille $N_{IDFT}$ constante (quelles que soient la numérologie et la bande). Le remplissage de zéros mis en oeuvre par le module de remplissage 32 en entrée de la transformée de Fourier inverse discrète IDFT (domaine fréquentiel) correspond à un sur-échantillonnage du signal dans le domaine temporel d'un facteur égal à : $N_{IDFT}/(2N_c)$.

Chaque modulateur OFDM $28_0$, $28_1$, ..., $28_i$, ..., $28_{M-1}$ comprend en outre, tel qu'illustré sur la figure 2, un module de conversion parallèle-série 36 configuré pour convertir les $N_{IDFT}$ sorties temporelles parallèles propres à être délivrées par le module de transformation 34 en un flux série d'échantillons temporels.

De plus, chaque modulateur OFDM $28_0$, $28_1$, ..., $28_i$, ..., $28_{M-1}$ comprend en outre, un module d'insertion 38, dont l'entrée est propre à être connectée à la sortie du module de conversion parallèle-série 36, le module d'insertion 38 étant configuré pour insérer un temps de garde, correspondant à un nombre $N_{cs}$ prédéterminé d'échantillons temporels additionnels constant indépendamment de la numérologie et de la bande de transmission dudit émetteur E.

Selon une première variante, le temps de garde correspond à un préfixe cyclique.

Selon une deuxième variante, le temps de garde correspond à un suffixe cyclique.

De plus, chaque modulateur OFDM $28_0$, $28_1$, ..., $28_i$, ..., $28_{M-1}$ comprend en outre un module de décimation 40, localisé en aval dudit module de transformation 34, le module de décimation 40 étant configuré pour décimer les échantillons temporels obtenus à partir dudit module de transformation 34 du facteur égal à $N_{IDFT}/(2N_c)$. Une telle décimation permet de retrouver le rythme souhaité.

Des exemples de décimation pour une taille constante $N_{IDFT}$ de transformée de Fourier inverse discrète IDFT telle que : $N_{IDFT} = 512$ ou encore $N_{IDFT} = 1024$ quelles que soient la numérologie et la bande de transmission sont illustrés notamment par le tableau 4 ci-dessous.

[Table 4]

| $N_c$ | Nombre de zéros | $N_{IDFT}$ | Décimation |
|---|---|---|---|
| 32 | 480 | 512 | 8 |
| 64 | 448 | | 4 |
| 128 | 384 | | 2 |
| 256 | 256 | | Aucune |
| 64 | 960 | 1024 | 8 |
| 128 | 896 | | 4 |
| 256 | 768 | | 2 |
| 512 | 512 | | Aucune |

En complément, chaque modulateur OFDM $28_0$, $28_1$, ..., $28_i$, ..., $28_{M-1}$ comprend en outre un module 42 de déplacement de spectre configuré pour appliquer aux échantillons, dans leur ordre d'arrivée, une rotation dans le domaine temporel de valeur de $(-1)^{i+1}\pi/2$, avec i l'indice associé audit modulateur OFDM.

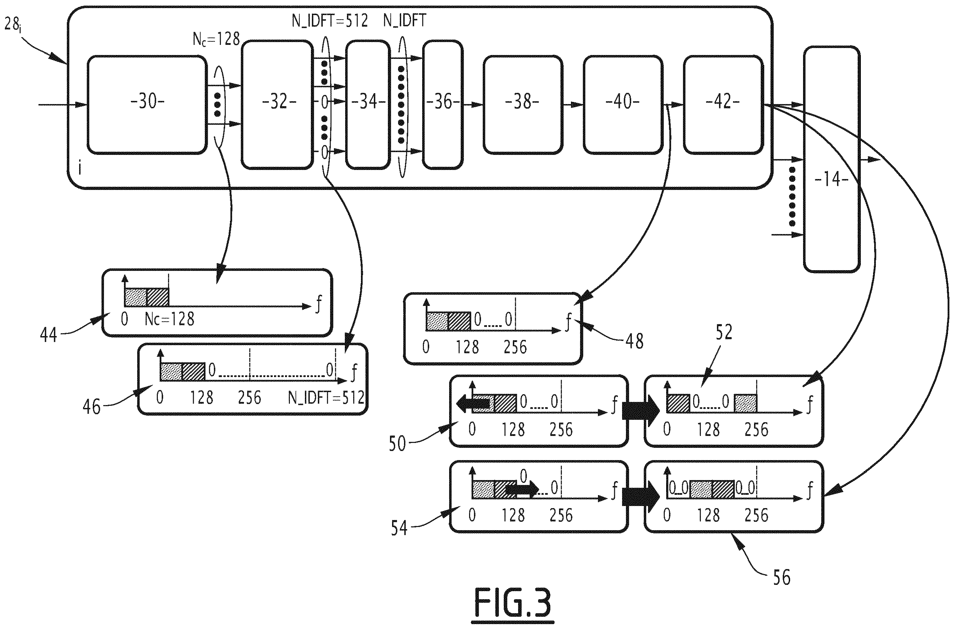

Un tel module 42 de déplacement de spectre (i.e. module 42 de rotation dans le domaine temporel) associé au module 32 de remplissage précédemment décrit, permet tel qu'illustré par la figure 3 de reproduire en sortie de chaque modulateur OFDM $28_0$, $28_1$, ..., $28_i$, ..., $28_{M-1}$ selon la présente invention, le formatage dont des exemples sont indiqués au sein du tableau 1, à la différence majeure près que l'architecture de modulateur proposée selon la présente invention ne nécessite pas d'interruption du flux de données.

Plus précisément, sur la figure 3, pour un nombre $N_c$ de porteuses de données tel que $N_c$ = 128, tel qu'illustré par la représentation 44, et avec une taille constante $N_{IDFT}$ de transformée de Fourier inverse discrète IDFT telle que : $N_{IDFT}$ = 512 quelles que soient la numérologie et la bande de transmission mise en oeuvre par le module de transformation 34, le module de remplissage 32 insère, à la suite des $N_c$ = 128 porteuses de données consécutives, un nombre de porteuses nulles égal à 512-128= 384, et ce indépendamment de la parité de l'indice i associé audit modulateur OFDM $28_0$, $28_1$, ..., $28_i$, ..., $28_{M-1}$, tel qu'illustré par la représentation 46.

Puis, tel qu'illustré par la représentation 48 de la figure 3, le traitement de décimation mis en oeuvre par le module de décimation 40 dans le domaine temporel, revient dans le domaine fréquentiel à la réduction du spectre d'un facteur deux, pour obtenir 256 porteuses avec toujours $N_c$ premières porteuses de données consécutives tel que $N_c$ = 128 et 128 porteuses nulles suivantes.

Le traitement mis en oeuvre par le module 42 de déplacement de spectre est illustré par les représentations, dans le domaine fréquentiel, 50 et 52 pour un modulateur OFDM (i.e. sous canal) d'indice i pair, et 54 et 56 pour un modulateur OFDM (i.e. sous canal) d'indice i impair.

Plus précisément, le module 42 de déplacement de spectre met en oeuvre une rotation dans le domaine temporel de valeur de $(-1)^{i+1}\pi/2$, avec i l'indice associé audit modulateur OFDM, si bien que pour un indice i pair, une telle rotation dans le domaine temporel revient à répartir, tel qu'illustré par les représentations 50 et 52, dans le domaine fréquentiel, les $N_c$ porteuses de données sur les côtés du spectre avec 128 porteuses nulles au milieu du spectre, les

$$\frac{N_c}{2} = 64$$ premières données (représentées avec une texture en pointillés) du flux entrant dans étant placées à la fin du spectre, alors que les $$\frac{N_c}{2} = 64$$ données suivantes (représentées avec une texture en diagonales) du flux entrant étant placées en début de spectre avec des porteuses nulles au milieu du spectre. Pour un indice i impair, une telle rotation dans le domaine temporel revient à répartir, tel qu'illustré par les représentations 54 et 56, dans le domaine fréquentiel, les $N_c$ porteuses de données au centre du spectre avec des porteuses nulles sur les côtés.

Autrement dit, en évitant une interruption du flux de données, le décalage à droite ou à gauche du spectre selon la parité de l'indice du sous-canal est contrôlé, selon la présente invention, simplement par le signe de la rotation mise en oeuvre par le module 42 de déplacement de spectre. Ce module 42 de déplacement de spectre utilise la propriété qu'une rotation dans le domaine temporel équivaut à un décalage spectral.

Avec l'architecture de l'émetteur E proposé selon la présente invention, les différents paramétrages de l'émetteur BF-OFDM en considérant un nombre M de modulateurs OFDM (i.e. sous-canaux) constant ; dont la largeur évolue avec la largeur B de bande passante de la bande de transmission, deviennent les paramétrages illustrés par le tableau 5 présenté ci-dessous, avec une bande de transmission et une numérologie $\mu = \{0,1,2,3\}$ (numéro associé à une valeur prédéterminée de l'espace entre porteuses $\Delta f$) propres toutes deux à varier respectivement et indépendamment en temps réel :

**[Table 5]**

| $\mu$ | $\Delta f$ (kHz) | $N_c$ | Band=50 MHz $N_c \Delta f$ = 3.84 MHz Taille IDFT | $N_{cs}$ | $N_c$ | Band= 100 MHz $N_c \Delta f$ = 7.68 MHz Taille IDFT | $N_{cs}$ | $N_c$ | Band=200 MHz $N_c \Delta f$ = 15.36 MHz Taille IDFT | $N_{cs}$ |
|---|---|---|---|---|---|---|---|---|---|---|
| 0 | 15 | 256 | | | 512 | | | 1024 | | |
| 1 | 30 | 128 | 2048 | 128 | 256 | 2048 | 128 | 512 | 2048 | 128 |
| 2 | 60 | 64 | | | 128 | | | 256 | | |
| 3 | 120 | 32 | | | 64 | | | 128 | | |

En comparaison avec le tableau 2 présenté en relation avec l'état de la technique, l'architecture de l'émetteur E selon la présente invention, quelles que soient la numérologie et la bande, se caractérise donc à la fois par une seule taille de transformée de Fourier inverse discrète IDFT ($N_{IDFT}$) et une seule taille d'intervalle de garde $N_{cs}$ utilisées.

L'architecture de l'émetteur E selon la présente invention permet ainsi une simplification de l'alternance de la position des zéros lors du formatage mis en oeuvre selon l'état de la technique, grâce au module de remplissage 32 précédemment décrit, complété par l'action dans le domaine temporel du module de décimation 40 et du module 42 de déplacement de spectre (ou encore de rotation dans le domaine temporel). L'insertion de zéros (i.e. de porteuses nulles), mise en oeuvre par le module de remplissage 32, ne requiert plus aucune opération d'indexation en fonction de la parité du sous-canal et ne nécessite pas d'interrompre le flux des données.

L'homme du métier comprendra que l'invention ne se limite pas aux modes de réalisation décrits, ni aux exemples particuliers de la description, les modes de réalisation et les variantes mentionnées ci-dessus étant propres à être combinés entre eux pour générer de nouveaux modes de réalisation de l'invention.

En particulier, l'architecture de modulateur OFDM $28_0$, $28_1$, ..., $28_i$, ..., $28_{M-1}$ proposée sur la figure 2, s'applique pour toute valeur de $M$ : les concepteurs du système choisissent $M$ en fonction de leurs propres objectifs. Autrement dit, le nombre $M$ de modulateurs OFDM $28_0$, $28_1$, ..., $28_i$, ..., $28_{M-1}$ est reconfigurable, ce paramètre $M$ ayant une influence sur la taille du banc de filtre 14 et sur la taille de la transformée de Fourier rapide FFT (de l'anglais *Fast Fourier Transform*) du récepteur d'un système d'émission/réception, non représenté, comprenant un émetteur E OFDM à filtrage par blocs selon la présente invention. La largeur $M$ des sous-canaux (i.e. modulateur OFDM $28_0$, $28_1$, ..., $28_i$, ..., $28_{M-1}$) est un paramètre de l'émetteur E OFDM propre à évoluer, une telle évolution étant prise en charge par l'invention.

La présente invention propose ainsi une architecture d'émetteur E OFDM, notamment compatible avec la version 15 de la norme 3GPP, 5G NR, ce qui la rend susceptible d'être utilisée par n'importe quel système se revendiquant de cette norme, notamment des systèmes dits « multi-services », mélangeant dans une même trame des services avec différentes exigences, particulièrement à même d'utiliser le BF-OFDM.

**Revendications**

1. Modulateur ($28_0$, $28_1$, ..., $28_i$, ..., $28_{M-1}$) OFDM d'un ensemble de $M$ modulateurs OFDM en parallèle d'un émetteur OFDM à filtrage par blocs propre à communiquer en utilisant une bande de transmission et une numérologie, variable(s) en temps réel,

chaque modulateur OFDM étant associé à un indice $i$ tel que $0 \leq i \leq M$ - 1, M étant constant indépendamment de la numérologie et de la bande de transmission dudit émetteur,

l'émetteur OFDM à filtrage par blocs comprenant en outre en amont dudit ensemble un module (16) de conversion série-parallèle configuré pour convertir un flux série de données entrantes en $N_{FFT}$ porteuses parallèles de données,

le modulateur OFDM ($28_0$, $28_1$, ..., $28_i$, ..., $28_{M-1}$) étant configuré pour recevoir en entrée un bloc de $N_c$ porteuses de données consécutives desdites $N_{FFT}$ porteuses parallèles de données,

le modulateur OFDM ($28_0$, $28_1$, ..., $28_i$, ..., $28_{M-1}$) comprenant au moins un module de prédistortion (30) configuré pour recevoir lesdites $N_c$ porteuses de données consécutives et configuré pour compenser une distorsion introduite ultérieurement par un banc (14) de filtres polyphasés dudit émetteur OFDM, la sortie dudit modulateur OFDM étant connectable à l'entrée du banc (14) de filtres polyphasés,
**caractérisé en ce que** le modulateur OFDM ($28_0$, $28_1$, ..., $28_i$, ..., $28_{M-1}$) comprend en outre :

- un module de transformation (34) configuré pour appliquer une transformée de Fourier inverse discrète IDFT de taille constante $N_{IDFT}$ indépendamment de la numérologie et de la bande de transmission dudit émetteur,
- un module de remplissage (32) dont l'entrée est connectée à la sortie du module de prédistortion (30), et dont la sortie est connecté à l'entrée du module de transformation (34), le module de remplissage (32) étant configuré pour insérer ($N_{IDFT}$- $N_c$) porteuses nulles à la suite des $N_c$ porteuses de données consécutives indépendamment de la parité de l'indice $i$ associé audit modulateur OFDM.

2. Modulateur OFDM ($28_0$, $28_1$, ..., $28_i$, ..., $28_{M-1}$) selon la revendication 1, dans lequel le modulateur OFDM ($28_0$, $28_1$, ..., $28_i$, ..., $28_{M-1}$) est propre à traiter les données selon leur ordre d'arrivée indépendamment de la valeur de son indice $i$.

3. Modulateur OFDM ($28_0$, $28_1$, ..., $28_i$, ..., $28_{M-1}$) selon la revendication 1 ou 2, dans lequel le modulateur OFDM ($28_0$, $28_1$, ..., $28_i$, ..., $28_{M-1}$) comprend en outre :

- un module de conversion parallèle-série (36) configuré pour convertir les $N_{IDFT}$ sorties temporelles parallèles propres à être délivrées par le module de transformation (34) en un flux série d'échantillons temporels, et
- un module d'insertion (38), dont l'entrée est propre à être connectée à la sortie du module de conversion parallèle-série (36), le module d'insertion (38) étant configuré pour insérer un temps de garde, correspondant à un nombre $N_{cs}$ prédéterminé d'échantillons temporels additionnels constant indépendamment de la numérologie et de la bande de transmission dudit émetteur.

4. Modulateur OFDM ($28_0$, $28_1$, ..., $28_i$, ..., $28_{M-1}$) selon la revendication 3, dans lequel le temps de garde correspond à un préfixe cyclique.

5. Modulateur OFDM ($28_0$, $28_1$, ..., $28_i$, ..., $28_{M-1}$) selon la revendication 3, dans lequel le temps de garde correspond à un suffixe cyclique.

6. Modulateur OFDM ($28_0$, $28_1$, ..., $28_i$, ..., $28_{M-1}$) selon l'une quelconque des revendications précédentes, dans lequel le modulateur OFDM ($28_0$, $28_1$, ..., $28_i$, ..., $28_{M-1}$) comprend en outre un module de décimation (40), localisé en aval dudit module de transformation (34), le module de décimation (40) étant configuré pour décimer les échantillons temporels obtenus à partir dudit module de transformation d'un facteur égal à $N_{IDFT}/(2N_c)$.

7. Modulateur OFDM ($28_0$, $28_1$, ..., $28_i$, ..., $28_{M-1}$) selon l'une quelconque des revendications précédentes, dans lequel le modulateur OFDM ($28_0$, $28_1$, ..., $28_i$, ..., $28_{M-1}$) comprend en outre un module (42) de déplacement de spectre configuré pour appliquer aux échantillons, dans leur ordre d'arrivée, une rotation dans le domaine temporel de valeur de $(-1)^{i+1}\pi/2$, avec $i$ l'indice associé audit modulateur OFDM.

8. Emetteur (E) OFDM à filtrage par blocs propre à communiquer en utilisant une bande de transmission et une numérologie variable(s) en temps réel, l'émetteur OFDM comprenant successivement :

- un module de conversion (16) série-parallèle configuré pour convertir un flux série de données entrantes en $N_{FFT}$ porteuses parallèles de données,
- un ensemble de $M$ modulateurs OFDM ($28_0$, $28_1$, ..., $28_i$, ..., $28_{M-1}$) en parallèle selon l'une quelconque des revendications précédentes, chaque modulateur OFDM ($28_0$, $28_1$, ..., $28_i$, ..., $28_{M-1}$) étant associé à un indice $i$ tel que $0 \le i \le M$ - 1, $M$ étant constant indépendamment de la numérologie et de la bande de transmission dudit émetteur, chaque modulateur OFDM ($28_0$, $28_1$, ..., $28_i$, ..., $28_{M-1}$) étant configuré pour recevoir en entrée un ensemble de $N_c$ porteuses de données consécutives desdites $N_{FFT}$ porteuses parallèles de données, les ensembles de $N_c$ porteuses consécutives traités par chaque modulateur ($28_0$, $28_1$, ..., $28_i$, ..., $28_{M-1}$) étant tous disjoints, $N_{FFT}$ étant égal à $M$ fois $N_c$,
- un banc (14) de filtres polyphasés propre à être connecté aux $M$ sorties dudit ensemble de $M$ modulateurs OFDM.

9. Emetteur OFDM à filtrage par blocs selon la revendication 8, dans lequel le nombre $M$ de modulateurs OFDM ($28_0$, $28_1$, ..., $28_i$, ..., $28_{M-1}$) est reconfigurable.

**10.** Système d'émission/réception comprenant un émetteur OFDM à filtrage par blocs selon la revendication 8 ou la revendication 9.

**Patentansprüche**

**1.** OFDM-Modulator ($28_0$, $28_i$, ..., $28_i$, ..., $28_{M-1}$) einer Anordnung von $M$ OFDM-Modulatoren parallel zu einem blockgefilterten OFDM-Sender, der geeignet ist, um unter Verwendung eines Übertragungsbands und einer Numerologie zu kommunizieren, die in Echtzeit variabel sind,

wobei jeder OFDM-Modulator mit einem Index $i$ assoziiert ist, sodass $0 \leq i \leq M$-1, wobei $M$ unabhängig von der Numerologie und dem Übertragungsband des Senders konstant ist,
der blockgefilterte OFDM-Sender ferner umfassend stromaufwärts von der Anordnung ein Modul (16) zur Umwandlung seriell-parallel umfasst, das konfiguriert ist, um einen seriellen Strom von eingehenden Daten in $N_{FFT}$ paralleler Datenträger umwandelt, wobei der OFDM-Modulator ($28_0$, 28, ..., $28_i$, ..., $28_{M-1}$) konfiguriert ist, um als Eingang einen Block von $N_c$ aufeinanderfolgenden Datenträgern der $N_{FFT}$ parallelen Datenträgern zu empfangen,
der OFDM-Modulator ($28_0$, $28_1$, ..., $28_i$, ..., $28_{M-1}$) umfassend mindestens ein Vorverzerrungsmodul (30) umfasst, das konfiguriert ist, um die $N_c$ aufeinanderfolgenden Datenträger empfangen, und konfiguriert ist, um eine Verzerrung zu kompensieren, die später durch eine Bank (14) von Mehrphasenfiltern des OFDM-Senders eingeführt wird, wobei der Ausgang des OFDM-Modulators mit dem Eingang der Bank (14) von Mehrphasenfiltern verbunden werden kann,
**dadurch gekennzeichnet, dass** der OFDM-Modulator ($28_0$, 28,, ..., $28_i$, ..., $28_{M-1}$) ferner Folgendes umfasst:

- ein Transformationsmodul (34), das konfiguriert ist, um eine diskrete inverse Fourier-Transformation IDFT mit konstanter Größe $N_{IDFT}$ unabhängig von der Numerologie und dem Übertragungsband des Senders anzuwenden,
- ein Füllmodul (32), dessen Eingang mit dem Ausgang des Vorverzerrungsmoduls (30) verbunden ist und, dessen Ausgang mit dem Eingang des Transformationsmoduls (34) verbunden ist, wobei das Füllmodul (32) konfiguriert ist, um $(N_{IDFT} - N_c)$ Nullträger nach $N_c$ aufeinanderfolgenden Datenträgern einzufügen, unabhängig von der Parität des Index i, der mit dem OFDM-Modulator assoziiert ist.

**2.** OFDM-Modulator ($28_0$, $28_1$, ..., $28_i$, ..., $28_{M-1}$) nach Anspruch 1, wobei der OFDM-Modulator ($28_0$, $28_1$, ..., $28_i$, ..., $28_{M-1}$) geeignet ist, um die Daten gemäß ihrer Ankunftsreihenfolge unabhängig von dem Wert seines Index $i$ zu verarbeiten.

**3.** OFDM-Modulator ($28_0$, $28_1$, ..., $28_i$, ..., $28_{M-1}$) nach Anspruch 1 oder 2, wobei der OFDM-Modulator ($28_0$, $28_1$, ..., $28_i$, ..., $28_{M-1}$) ferner Folgendes umfasst:

- ein parallel-seriell-Umwandlungsmodul (36), das konfiguriert ist, um die parallelen zeitlichen $N_{IDFT}$-Ausgaben, die geeignet sind, um von dem Transformationsmodul (34) ausgegeben zu werden, in einen seriellen Strom von zeitlichen Abtastwerten umzuwandeln, und
- ein Einfügemodul (38), dessen Eingang geeignet ist, um mit dem Ausgang des Parallel-Seriell-Umwandlungsmoduls (36) verbunden zu werden, wobei das Einfügemodul (38) konfiguriert ist, um eine Schutzzeit einzufügen, die einer vorbestimmten Anzahl $N_{cs}$ von zusätzlichen Zeitabtastungen entspricht, die unabhängig von der Numerologie und dem Übertragungsband des Senders konstant ist.

**4.** OFDM-Modulator ($28_0$, $28_1$, ..., $28_i$, ..., $28_{M-1}$) nach Anspruch 3, wobei die Schutzzeit einem zyklischen Präfix entspricht.

**5.** OFDM-Modulator ($28_0$, $28_1$, ..., $28_i$, ..., $28_{M-1}$) nach Anspruch 3, wobei die Schutzzeit einem zyklischen Suffix entspricht.

**6.** OFDM-Modulator ($28_0$, $28_1$, ..., $28_i$, ..., $28_{M-1}$) nach einem der vorherigen Ansprüche, wobei der OFDM-Modulator ($28_0$, $28_1$, ..., $28_i$, ..., $28_{M-1}$) ferner ein Dezimierungsmodul (40) umfasst, das stromabwärts von dem Transformationsmodul (34) angeordnet ist, wobei das Dezimierungsmodul (40) konfiguriert ist, um die von dem Transformationsmodul erhaltenen Zeitabtastwerte um einen Faktor gleich $N_{IDFT}/(2N_C)$ zu dezimieren.

7. OFDM-Modulator ($28_0$, $28_1$, ..., $28_i$, ..., $28_{M-1}$) nach einem der vorherigen Ansprüche, wobei der OFDM-Modulator ($28_0$, $28_1$, ..., $28_i$, ..., $28_{M-1}$) ferner ein Spektralverschiebungsmodul (42) umfasst, das konfiguriert ist, um auf die Abtastwerte in ihrer Ankunftsreihenfolge eine Rotation in dem Zeitbereich mit dem Wert $(-1)^{i+1}\pi/2$ anzuwenden, wobei i der Index ist, der mit dem OFDM-Modulator assoziiert ist.

8. Blockgefilterter OFDM-Sender (E), der geeignet ist, um unter Verwendung eines variablen Übertragungsbands und einer variablen Numerologie(n) in Echtzeit zu kommunizieren, der OFDM-Sender nacheinander umfassend:

   - ein Umwandlungsmodul (16) seriell-parallel, das konfiguriert ist, um einen eingehenden seriellen Datenstrom in $N_{FFT}$ paralleler Datenträger umzuwandeln,
   - einen Satz von $M$ parallelen OFDM-Modulatoren ($28_0$, $28_1$, ..., $28_i$, ..., $28_{M-1}$) nach einem der vorhergehenden Ansprüche, wobei jeder OFDM-Modulator ($28_0$, $28_1$, ..., $28_i$, ..., $28_{M-1}$) mit einem Index i assoziiert ist, sodass $0 \leq i \leq M$-1, wobei M unabhängig von der Numerologie und dem Übertragungsband des Senders konstant ist, wobei jeder OFDM-Modulator ($28_0$, $28_1$, ..., $28_i$, ..., $28_{M-1}$) konfiguriert ist, um an dem Eingang eine Anordnung von $N_c$ aufeinanderfolgenden Datenträgern der $N_{FFT}$ parallelen Datenträger zu empfangen, wobei die Anordnungen von $N_c$ aufeinanderfolgenden Trägern, die von jedem Modulator ($28_0$, $28_1$, ..., $28_i$, ..., $28_{M-1}$) verarbeitet werden, alle disjunkt sind, wobei $N_{FFT}$ gleich $M$ mal $N_c$ ist,
   - eine Bank (14) von Mehrphasenfiltern, die geeignet ist, um mit den $M$ Ausgängen der Anordnung von $M$ OFDM-Modulatoren verbunden zu werden.

9. Blockgefilterter OFDM-Sender nach Anspruch 8, wobei die Anzahl $M$ von OFDM-Modulatoren ($28_0$, $28_1$, ..., $28_i$, ..., $28_{M-1}$) rekonfigurierbar ist.

10. Sende-/Empfangssystem, umfassend einen blockgefilterten OFDM-Sender nach Anspruch 8 oder Anspruch 9.

**Claims**

1. An OFDM modulator ($28_0$, $28_1$, ..., $28_i$, ..., $28_{M-1}$) of a set of $M$ OFDM modulators in parallel with a block filtered OFDM transmitter suitable for communication using a transmission band and a numbering, variable in real time,

   each OFDM modulator being associated with an index i such that $0 \leq i \leq M$ - 1, $M$ being constant independently of the numbering and transmission band of said transmitter,
   the block-filtered OFDM transmitter further comprising a serial-to-parallel conversion module (16) upstream of said assembly, configured to convert an incoming serial data stream into $N_{FFT}$ parallel data carriers,
   the OFDM modulator ($28_0$, $28_1$, ..., $28_i$, ..., $28_{M-1}$) being configured to receive a block of $N_c$ consecutive data carriers of said $N_{FFT}$ parallel data carriers as input,
   the OFDM modulator ($28_0$, $28_1$, ..., $28_i$, ..., $28_{M-1}$) comprising at least one predistortion module (30) configured to receive said $N_c$ consecutive data carriers and configured to compensate for distortion subsequently introduced by a polyphase filter bank (14) of said OFDM transmitter, the output of said OFDM modulator being connectable to the input of the polyphase filter bank (14)
   **characterized in that** the OFDM modulator ($28_0$, $28_1$, ..., $28_i$, ..., $28_{M-1}$) further comprises:

   - a transformation module (34) configured to apply a discrete inverse Fourier transform IDFT of constant size $N_{IDFT}$ independently of the numbering and transmission band of said transmitter,
   - a filling module (32) the input of which is connected to the output of the predistortion module (30), and the output of which is connected to the input of the transformation module (34), the filling module (32) being configured to insert ($N_{IDFT}$ - $N_c$) null carriers in succession to the $N_c$ consecutive data carriers independently of the parity of the index i associated with said OFDM modulator

2. The OFDM modulator ($28_0$, $28_1$, ..., $28_i$, ..., $28_{M-1}$) according to claim 1, wherein the OFDM modulator ($28_0$, $28_1$, ..., $28_i$, ..., $28_{M-1}$) is adapted to process the data according to their order of arrival independently of the value of its index i.

3. The OFDM modulator ($28_0$, $28_1$, ..., $28_i$, ..., $28_{M-1}$) according to claim 1 or 2, wherein the OFDM modulator ($28_0$, $28_1$, ..., $28_i$, ..., $28_{M-1}$) further comprises:

   - a parallel-to-serial conversion module (36) configured to convert the $N_{IDFT}$ parallel time outputs suitable for output from the transformation module (34) into a serial stream of time samples, and

- an insertion module (38), the input of which is adapted to be connected to the output of the parallel-serial conversion module (36), the insertion module (38) being configured to insert a guard time, corresponding to a predetermined number $N_{cs}$ of additional time samples constant independently of the numbering and the transmission band of said transmitter.

4. The OFDM modulator ($28_0$, $28_1$, ..., $28_i$, ..., $28_{M-1}$) according to claim 3, wherein the guard time corresponds to a cyclic prefix.

5. The OFDM modulator ($28_0$, $28_1$, ..., $28_i$, ..., $28_{M-1}$) according to claim 3, wherein the guard time corresponds to a cyclic suffix.

6. The OFDM modulator ($28_0$, $28_1$, ..., $28_i$, ..., $28_{M-1}$) according to any of the preceding claims, wherein the OFDM modulator ($28_0$, $28_1$, ..., $28_i$, ..., $28_{M-1}$) further comprises a decimation module (40), located downstream of said transformation module (34), the decimation module (40) being configured to decimate the time samples obtained from said transformation module by a factor equal to $N_{IDFT}/(2N_c)$.

7. The OFDM modulator ($28_0$, $28_1$, ..., $28_i$, ..., $28_{M-1}$) according to any of the preceding claims, wherein the OFDM modulator ($28_0$, $28_1$, ..., $28_i$, ..., $28_{M-1}$) further comprises a spectrum shifting module (42) configured to apply to the samples, in their order of arrival, a rotation in the time domain of value of $(-1)^{i+1}\pi/2$, where $i$ is the indexed associated with said OFDM modulator.

8. A block-filtered OFDM transmitter (E) suitable for communicating using a variable transmission band and numbering in real time, the OFDM transmitter comprising successively:

   - a serial-to-parallel conversion module (16) configured to convert an incoming serial data stream into $N_{FFT}$ parallel data carriers,
   - a set of M OFDM modulators ($28_0$, $28_1$, ..., $28_i$, ..., $28_{M-1}$) in parallel according to any of the preceding claims, each OFDM modulator ($28_0$, $28_1$, ..., $28_i$, ..., $28_{M-1}$) being associated with an index i such that $0 \leq i \leq M - 1$, $M$ being constant regardless of the numbering and transmission band of said transmitter, each OFDM modulator ($28_0$, $28_1$, ..., $28_i$, ..., $28_{M-1}$) being configured to receive as input a set of $N_c$ consecutive data carriers of said $N_{FFT}$ parallel data carriers, the sets of $N_c$ consecutive carriers processed by each modulator ($28_0$, $28_1$, ..., $28_i$, ..., $28_{M-1}$) being all disjoint, $N_{FFT}$ being equal to $M$ times $N_c$,
   - a bank (14) of polyphase filters adapted to be connected to the M outputs of said set of $M$ OFDM modulators.

9. The block-filtered OFDM transmitter according to claim 8, wherein the number $M$ of OFDM modulators ($28_0$, $28_1$, ..., $28_i$, ..., $28_{M-1}$) is reconfigurable.

10. A transceiver comprising a block-filtered OFDM transmitter according to claim 8 or claim 9.

FIG.1

FIG.2

## FIG.3

**RÉFÉRENCES CITÉES DANS LA DESCRIPTION**

**Littérature non-brevet citée dans la description**

- Block-Filtered OFDM: a novel waveform for future Wireless. *IEEE ICC 2017 Wireless Communications Symposium technologies,* 21 Mai 2017